# EUROPÄISCHE PATENTSCHRIFT

(11) **EP 1 668 645 B1**
(45) Veröffentlichungstag und Bekanntmachung des Hinweises auf die Patenterteilung: **15.08.2007**
(21) Anmeldenummer: 04766761.3
(22) Anmeldetag: 10.09.2004
(51) Int. Cl.: G11C 7/22, G11C 11/4076

(54) **TAKT-RECEIVER-SCHALTUNGSANORDNUNG, INSBESONDERE FÜR HALBLEITER-BAUELEMENTE**
CLOCK RECEIVER CIRCUIT ARRANGEMENT, ESPECIALLY FOR SEMICONDUCTOR COMPONENTS
CIRCUIT DE RECEPTION DE SIGNAUX D'HORLOGE CONCU EN PARTICULIER POUR DES DISPOSITIFS A SEMI-CONDUCTEUR

(30) Priorität: 30.09.2003 DE 10345491
(43) Veröffentlichungstag der Anmeldung: 14.06.2006
(73) Patentinhaber: Infineon Technologies AG, 81669 München (DE)
(72) Erfinder: MINZONI, Alessandro, Morrisville, North Carolina 27560 (US)
(74) Vertreter: Jehle, Volker Armin
(86) Internationale Anmeldenummer: PCT/EP2004/052126
(87) Internationale Veröffentlichungsnummer: WO 2005/034131

(56) Entgegenhaltungen:
- US-A- 5 852 378
- US-A1- 2002 140 481
- US-B1- 6 184 730
- US-B1- 6 292 042

## Beschreibung

Die Erfindung betrifft ein Halbleiter-Bauelement mit einer Takt-Receiver-Schaltungsanordnung.

Bei Halbleiter-Bauelementen, insbesondere bei Speicherbauelementen wie - z.B. auf CMOS-Technologie beruhenden - DRAMs (DRAM = Dynamic Random Access Memory bzw. dynamischer Schreib-Lese-Speicher) werden - zur zeitlichen Koordination der Verarbeitung bzw. Weiterschaltung der Daten - sog. Taktsignale verwendet.

Bei herkömmlichen Halbleiter-Bauelementen wird dabei i.A. ein - auf einer Einzel-Leitung anliegendes - Einzel-Taktsignal eingesetzt (d.h. ein sog. "single ended"-Taktsignal).

Die Daten können dann z.B. jeweils bei der ansteigenden Taktflanke des Einzel-Taktsignals weitergeschaltet werden (oder alternativ z.B. jeweils bei der abfallenden Einzel-Taktsignal-Flanke).

Des weiteren sind im Stand der Technik bereits sog. DDR-Bauelemente, insbesondere DDR-DRAMs bekannt (DDR-DRAM = Double Data Rate - DRAM bzw. DRAM mit doppelter Datenrate).

Bei DDR-Bauelementen werden - statt eines einzelnen, auf einer Einzel-Leitung anliegenden Taktsignals ("single ended"-Taktsignal) - zwei auf zwei getrennten Leitungen anliegende, differentielle, gegengleich-inverse Taktsignale verwendet.

Immer dann, wenn z.B. das erste Taktsignal der beiden Taktsignale von einem Zustand "logisch hoch" (z.B. einem hohen Spannungspegel) auf einen Zustand "logisch niedrig" (z.B. einen niedrigen Spannungspegel) wechselt, ändert das zweite Taktsignal - im wesentlichen gleichzeitig - seinen Zustand von "logisch niedrig" auf "logisch hoch" (z.B. von einem niedrigen auf einen hohen Spannungspegel).

Umgekehrt ändert immer dann, wenn das erste Taktsignal von einem Zustand "logisch niedrig" (z.B. einem niedrigen Spannungspegel) auf einen Zustand "logisch hoch" (z.B. einen hohen Spannungspegel) wechselt, das zweite Taktsignal (wiederum im wesentlichen gleichzeitig) seinen Zustand von "logisch hoch" auf "logisch niedrig" (z.B. von einem hohen auf einen niedrigen Spannungspegel).

In DDR-Bauelementen werden die Daten i.A. sowohl bei der ansteigenden Flanke des ersten Taktsignals, als auch bei der ansteigenden Flanke des zweiten Taktsignals (bzw. sowohl bei der abfallenden Flanke des ersten Taktsignals, als auch bei der abfallenden Flanke des zweiten Taktsignals) weitergeschaltet.

Damit erfolgt in einem DDR-Bauelement die Weiterschaltung der Daten häufiger bzw. schneller (insbesondere doppelt so häufig, bzw. doppelt so schnell), wie bei entsprechenden, herkömmlichen Bauelementen mit Einzel- bzw. "single ended" - Taktsignal - d.h. die Datenrate ist höher, insbesondere doppelt so hoch, wie bei entsprechenden, herkömmlichen Bauelementen.

DDR-Bauelemente weisen z.B. zwei - externe - Taktanschlüsse auf, an denen - von einem externen Taktgeber - entsprechende differentielle Taktsignale clk, bclk angelegt, und - direkt - an entsprechende Eingänge einer Takt-Receiver-Schaltung weitergeleitet werden.

Herkömmliche Takt-Receiver-Schaltungsanordnungen weisen z.B. vier Transistoren auf, z.B. einen ersten und einen zweiten p-Kanal-Feldeffekttransistor (z.B. zwei p-Kanal-MOSFETs), sowie einen ersten und einen zweiten n-Kanal-Feldeffekttransistor (z.B. zwei n-Kanal-MOSFETs).

Die Source des ersten n-Kanal-Feldeffekttransistors kann über entsprechende Leitungen an eine - mit dem Massepotential verbundene - (Gleich- bzw. Konstant-) Strom-Quelle angeschlossen sein. Auf entsprechende Weise kann auch die Source des zweiten n-Kanal-Feldeffekttransistors über entsprechende Leitungen an die - mit dem Massepotential verbundene - (Gleich- bzw. Konstant-) Strom-Quelle angeschlossen sein.

Des weiteren kann das Gate des ersten n-Kanal-Feldeffekttransistors der Takt-Receiver-Schaltung z.B. mit dem o.g. (ersten) Eingang der Schaltung verbunden sein (an dem z.B. das o.g. - erste - Taktsignal clk anliegt), und das Gate des zweiten n-Kanal-Feldeffekttransistors z.B. mit dem o.g. (zweiten) Eingang der Schaltung (an dem z.B. das o.g. zweite, zum ersten Taktsignal clk inverse Taktsignal bclk anliegt).

Der Drain des ersten n-Kanal-Feldeffekttransistors kann über eine entsprechende Leitung an das Gate des ersten und zweiten p-Kanal-Feldeffekttransistors angeschlossen sein, und an den Drain des ersten p-Kanal-Feldeffekttransistors, sowie - über eine entsprechende Leitung - an einen (ersten) Ausgang der Takt-Receiver-Schaltung (an der ein (erstes) Ausgangs-Signal bout abgegriffen werden kann).

Auf entsprechende Weise kann der Drain des zweiten n-Kanal-Feldeffekttransistors an den Drain des zweiten p-Kanal-Feldeffekttransistors angeschlossen sein, sowie - über eine entsprechende, weitere Leitung - an einen (zweiten) Ausgang der Takt-Receiver-Schaltung (an der ein (zweites) Ausgangs-Signal out abgegriffen werden kann).

Die Source des ersten und zweiten p-Kanal-Feldeffekttransistors kann jeweils an die entsprechende Versorgungsspannung vddq angeschlossen sein.

Das erste von der Takt-Receiver-Schaltung ausgegebene Ausgangs-Signal bout entspricht dem am (zweiten) Eingang der Takt-Receiver-Schaltung anliegenden Signal bclk, und das zweite von der Takt-Receiver-Schaltung ausgegebene Ausgangs-Signal out dem am (ersten) Eingang der Takt-Receiver-Schaltung anliegenden Signal clk (wobei - je nach Art des Zustandswechsels der Eingangs-Signale clk bzw. bclk (z.B. von "logisch hoch", auf "logisch niedrig", oder umgekehrt) - die durch die Takt-Receiver-Schaltung hervorgerufenen Verzögerungszeiten relativ stark unterschiedlich sein können).

Die von der Takt-Receiver-Schaltung ausgegebenen AusgangsSignale out, bout können an weitere, im Halbleiter-Bauelement vorgesehene Schaltungen weitergeleitet, und dort z.B. zur zeitlichen Koordination der Verarbeitung bzw. Weiterschaltung von Daten, d.h. als differentielle Takt-Signale out, bout verwendet werden.

Aus der US 6 292 042 ist ein Phasensplitter bekannt, bei dem ein einzelnes Taktsignal in zwei gegenphasige Taktsignale aufgesplittet wird.

Die Erfindung hat zur Aufgabe, eine neuartige Receiver-, insbesondere Takt- Receiver-Schaltungsanordnung zur Verfügung zu stellen, sowie ein Halbleiter-Bauelement mit einer derartigen Schaltungsanordnung.

Sie erreicht dieses und weitere Ziele durch den Gegenstand des Anspruchs 1.

Vorteilhafte Weiterbildungen der Erfindung sind in den Unteransprüchen angegeben.

Dadurch wird erreicht, dass jedes Mal dann, wenn ein entsprechendes, erstes Transfergate "eingeschaltet" ist, ein diesem Transfergate zugeordnetes - an dieselbe Ausgangs-Leitung angeschlossenes -, komplementäres, zweites Transfergate "ausgeschaltet" ist (und umgekehrt), und entsprechend, dass jedes Mal dann, wenn ein entsprechendes, drittes Transfergate "ausgeschaltet" ist, ein diesem Transfergate zugeordnetes - an dieselbe Ausgangs-Leitung angeschlossenes -, komplementäres, viertes Transfergate "eingeschaltet" ist (und umgekehrt).

Im folgenden wird die Erfindung anhand eines Ausführungsbeispiels und der beigefügten Zeichnung näher erläutert. In der Zeichnung zeigt:
Figur 1 eine schematische Darstellung einer Receiver-, insbesondere Takt-Receiver-Schaltungsanordnung gemäß einem Ausführungsbeispiel der vorliegenden Erfindung;
Figur 2 eine schematische Darstellung des zeitlichen Verlaufs der an der Takt-Receiver-Schaltungsanordnung gemäß Figur 1 anliegenden Eingangs-Taktsignale (clk; bclk), und der von der Takt-Receiver-Schaltungsanordnung ausgegebenen Ausgangssignale (out; bout); und
Figur 3 eine schematische Darstellung einer Receiver-, insbesondere Takt-Receiver-Schaltungsanordnung gemäß einem weiteren Ausführungsbeispiel der vorliegenden Erfindung.

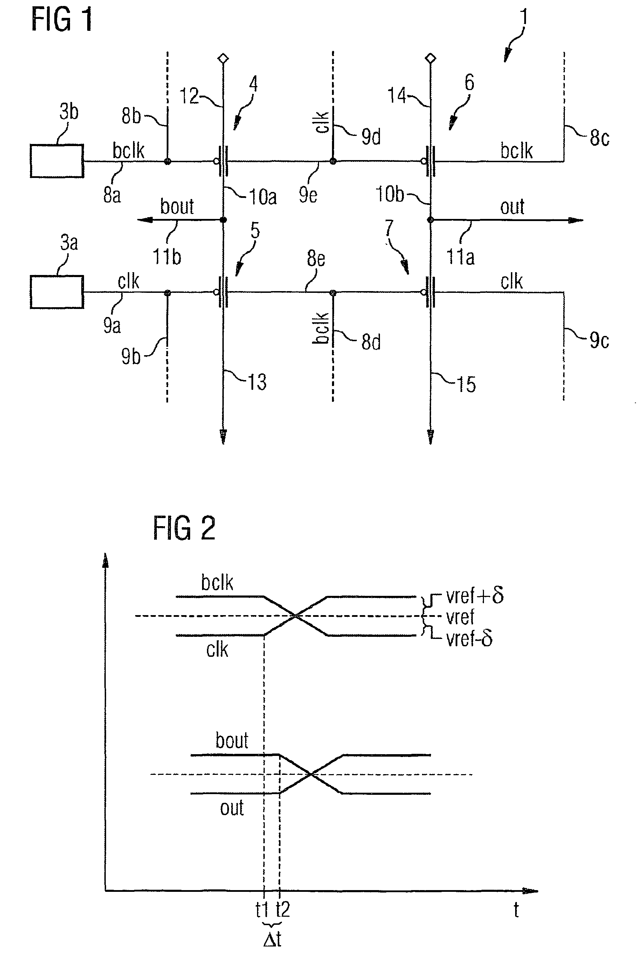

In Figur 1 ist eine schematische Darstellung einer Receiver-, insbesondere Takt-Receiver-Schaltungsanordnung 1 gemäß einem Ausführungsbeispiel der vorliegenden Erfindung gezeigt.

Die Schaltungsanordnung 1 kann z.B. in ein Halbleiter-Bauelement eingebaut sein, z.B. in ein - auf CMOS-Technologie beruhendes - DRAM-Speicherbauelement (DRAM = Dynamic Random Access Memory bzw. dynamischer Schreib-Lese-Speicher).

Beim DRAM-Speicherbauelement kann es sich z.B. um ein DDR-DRAM (DDR-DRAM = Double Data Rate - DRAM bzw. DRAM mit doppelter Datenrate) handeln.

Dieses weist zwei Eingangs-Taktanschlüsse 3a, 3b (z.B. entsprechende, mit entsprechenden Pins verbundene Bauelement-Pads) auf, wobei an den ersten Taktanschluß 3a ein - von einem externen Taktsignal-Geber, d.h. von außen her stammendes - erstes Taktsignal clk angelegt wird, und an den zweiten Taktanschluß 3b - ebenfalls durch den externen Taktsignal-Geber - ein zweites Taktsignal bclk.

Bei den beiden Taktsignalen clk und bclk kann es sich z.B. - wie in Figur 2 veranschaulicht ist - um sog. differentielle, d.h. gegengleich-inverse Taktsignale handeln: Immer dann, wenn z.B. das erste Taktsignal clk von einem Zustand "logisch hoch" auf einen Zustand "logisch niedrig" wechselt, wechselt das zweite Taktsignal bclk - im wesentlichen gleichzeitig - seinen Zustand von "logisch niedrig" auf "logisch hoch".

Umgekehrt wechselt immer dann, wenn das erste Taktsignal clk von einem Zustand "logisch niedrig" auf einen Zustand "logisch hoch" wechselt (in Figur 2 z.B. zum Zeitpunkt t1), das zweite Taktsignal bclk - im wesentlichen gleichzeitig (d.h. in Figur 2 z.B. - ebenfalls - zum Zeitpunkt t1) - seinen Zustand von "logisch hoch" auf "logisch niedrig".

Die o.g. (- gegenüber herkömmlichen, nur ein einzelnes (single ended) Taktsignal CLK verwendenden Bauelementen -) doppelte Datenrate wird im DDR-Bauelement dadurch erreicht, dass die jeweiligen Daten - innerhalb des DDR-Bauelements - nicht nur z.B. jeweils bei der ansteigenden (oder alternativ bei der abfallenden) Taktflanke eines einzelnen (single ended) Taktsignals weitergeschaltet werden, sondern sowohl bei der ansteigenden Flanke des ersten Taktsignals clk, als auch bei der ansteigenden Flanke des zweiten Taktsignals bclk (bzw. sowohl bei der abfallenden Flanke des ersten Taktsignals clk, als auch bei der abfallenden Flanke des zweiten Taktsignals bclk) (bzw. bei entsprechenden Flanken hieraus gewonnener Signale out, bout bzw. out', bout' (s.u.)) - d.h. doppelt so häufig, wie bei herkömmlichen Bauelementen mit einem einzelnen (single ended) Taktsignal CLK.

Wie in Figur 1 gezeigt ist, weist die Takt-Receiver-Schaltungsanordnung 1 vier Transfergates bzw. Transmissiongates 4, 5, 6, 7 auf.

Jedes Transfergate 4, 5, 6, 7 weist - entsprechend wie herkömmliche Transfergates - jeweils einen (ersten) Steuereingang, und einen (zweiten, inversen) Steuereingang auf.

Die Transfergates 4, 5, 6, 7 können z.B. - entsprechend wie bei herkömmliche Transfergates - jeweils einen n- und einen p-Kanal-MOSFET aufweisen, wobei das Gate des n-Kanal-MOSFETS z.B. jeweils mit dem ersten Steuereingang des jeweiligen Transfergates 4, 5, 6, 7, und das Gate des p-Kanal-MOSFETs z.B. jeweils mit dem zweiten (inversen) Steuereingang des jeweiligen Transfergates 4, 5, 6, 7 verbunden sein kann (oder umgekehrt).

Des weiteren sind bei den Transfergates 4, 5, 6, 7 - entsprechend wie bei herkömmliche Transfergates - z.B. jeweils die Source des n- und die Source des p-Kanal-MOSFETs miteinander verbunden, und an einen entsprechenden (ersten) Transfergate-Anschluß angeschlossen, und - entsprechend - z.B. jeweils der Drain des n- und der Drain des p-Kanal-MOSFETs miteinander verbunden, und an einen entsprechenden (zweiten) Transfergate-Anschluß angeschlossen (oder umgekehrt).

Wie aus Figur 1 hervorgeht, ist bei der Takt-Receiver-Schaltungsanordnung 1 der Taktanschluss 3a - an dem, wie oben erläutert, das Taktsignal clk anliegt - über eine Leitung 9a mit dem zweiten (inversen) Steuereingang des Transfergates 5 verbunden (dem zweiten, inversen Steuereingang des Transfergates 5 wird somit das o.g. - erste - Taktsignal clk zugeführt).

Die Leitung 9a ist über eine mit dieser verbundenen Leitung 9b an eine Leitung 9c angeschlossen, die mit dem ersten (nicht-inversen) Steuereingang des Transfergates 7 verbunden ist (dem ersten, nicht-inversen Steuereingang des Transfergates 7 wird somit - ebenfalls - das o.g. - erste - Taktsignal clk zugeführt).

Wie aus Figur 1 weiter hervorgeht, ist bei der Takt-Receiver-Schaltungsanordnung 1 der Taktanschluss 3b - an dem, wie oben erläutert, das zweite, inverse Taktsignal bclk anliegt - über eine Leitung 8a mit dem zweiten (inversen) Steuereingang des Transfergates 4 verbunden (dem zweiten, inversen Steuereingang des Transfergates 4 wird somit das o.g. - zweite - Taktsignal bclk zugeführt).

Die Leitung 8a ist über eine mit dieser verbundenen Leitung 8b an eine Leitung 8c angeschlossen, die mit dem ersten, nicht-inversen Steuereingang des Transfergates 6 verbunden ist (dem ersten, nicht-inversen Steuereingang des Transfergates 6 wird somit - ebenfalls - das o.g. zweite, inverse Taktsignal bclk zugeführt).

Des weiteren ist die Leitung 8a - an der, wie oben erläutert, das zweite, inverse Taktsignal bclk anliegt - über die mit dieser verbundenen Leitung 8b an eine Leitung 8d angeschlossen, die an eine weitere Leitung 8e angeschlossen ist, die mit dem ersten (nicht-inversen) Steuereingang des Transfergates 5 verbunden ist, und mit dem zweiten, inversen Steuereingang des Transfergates 7 (dem ersten, nicht-inversen Steuereingang des Transfergates 5, und dem zweiten, inversen Steuereingang des Transfergates 7 wird somit - ebenfalls - das o.g. zweite, inverse Taktsignal bclk zugeführt).

Wie in Figur 1 weiter gezeigt ist, ist die Leitung 9a - an der, wie oben erläutert, das erste Taktsignal clk anliegt - über die mit dieser verbundenen Leitung 9b an eine Leitung 9d angeschlossen, die an eine weitere Leitung 9e angeschlossen ist, die mit dem zweiten, inversen Steuereingang des Transfergates 6 verbunden ist, und mit dem ersten, nicht-inversen Steuereingang des Transfergates 4 (dem zweiten, inversen Steuereingang des Transfergates 6, und dem ersten, nicht-inversen Steuereingang des Transfergates 4 wird somit - ebenfalls - das o.g., erste Taktsignal clk zugeführt).

Gemäß Figur 1 ist - über eine Leitung 10a - jeweils der erste (oder der zweite) Transfergate-Anschluß des Transfergates 4 an den - inversen - zweiten (oder ersten) Transfergate-Anschluß des Transfergates 5 angeschlossen.

Entsprechend ist - über eine Leitung 10b - jeweils der erste (oder der zweite) Transfergate-Anschluß des Transfergates 6 an den - inversen - zweiten (oder ersten) Transfergate-Anschluß des Transfergates 7 angeschlossen.

Die Leitung 10b, an der das entsprechende, an den entsprechenden Transfergateanschlüssen der Transfergates 6, 7 ausgegebene Signal abgegriffen werden kann, ist mit einer Ausgangs-Leitung 11a verbunden, an der das erste - und wie in Figur 2 dargestellt, und wie im folgenden noch genauer erläutert wird, dem ersten Taktsignal clk entsprechende - Ausgangssignal der Takt-Receiver-Schaltungsanordnung abgegriffen werden kann (erstes Ausgangssignal out).

Auf entsprechende Weise ist auch die Leitung 10a, an der das entsprechende, an den entsprechenden Transfergateanschlüssen der Transfergates 4, 5 ausgegebene Signal abgegriffen werden kann, mit einer (weiteren) Ausgangs-Leitung 11b verbunden, an der das zweite - und wie in Figur 2 dargestellt, und wie im folgenden noch genauer erläutert wird, dem zweiten Taktsignal bclk entsprechende - Ausgangssignal der Takt-Receiver-Schaltungsanordnung abgegriffen werden kann (zweites Ausgangssignal bout).

Wie in Figur 1 weiter gezeigt ist, ist - über eine Leitung 12 - der weitere (zweite (oder erste)) Transfergate-Anschluß des Transfergates 4 an die Versorgungsspannung vddq angeschlossen (die z.B. zwischen 2,5 V und 3,5 V, insbesondere z.B. 2,5 V oder 2,9 V betragen kann).

Des weiteren ist der weitere - inverse - (erste (oder zweite)) Transfergate-Anschluß des Transfergates 5 an das Massepotential angeschlossen.

Entsprechend ähnlich wie beim Transfergate 4 ist auch beim Transfergate 6 - über eine Leitung 14 - der weitere (zweite (oder erste)) Transfergate-Anschluß an die o.g. Versorgungsspannung vddq angeschlossen.

Des weiteren ist - entsprechend ähnlich wie beim Transfergate 5 - auch beim Transfergate 7 der weitere - inverse - (erste (oder zweite)) Transfergate-Anschluß an das Massepotential angeschlossen.

Der Spannungspegel des ersten und zweiten Ausgangssignals out, bout (im jeweils "logisch hohen" Zustand) kann z.B. ca. die Hälfte des Spannungspegels der o.g. Versorgungsspannung vddq betragen, z.B. zwischen 1,25 V und 1,75 V, insbesondere z.B. 1,25 V oder 1,45 V.

Liegt z.B. - wie in Figur 2 dargestellt z.B. in einer ersten Taktphase, d.h. hier bis zu einem Zeitpunkt t1 (und insbesondere bei der o.g. Alternative) - am ersten Taktanschluss 3a ein "logisch niedriges" erstes Taktsignal clk an (und damit auch - über die Leitung 9c - am ersten, nicht-inversen Steuereingang des Transfergates 7, - über die Leitung 9e - am ersten, nicht-inversen Steuereingang des Transfergates 6, - über die Leitung 9e - am zweiten, inversen Steuereingang des Transfergates 4, und - über die Leitung 9a - am zweiten, inversen Steuereingang des Transfergates 5 ein entsprechendes, "logisch niedriges" Signal), und liegt - in der gleichen Taktphase - am zweiten Taktanschluß 3b ein "logisch hohes" zweites Taktsignal bclk an (und damit auch - über die Leitung 8e - am zweiten, inversen Steuereingang des Transfergates 7, - über die Leitung 8c - am zweiten, inversen Steuereingang des Transfergates 6, - über die Leitung 8a - am ersten, nicht-inversen Steuereingang des Transfergates 4, und - über die Leitung 8e - am ersten, nicht-inversen Steuereingang des Transfergates 5 ein entsprechendes, "logisch hohes" Signal), wird das Transfergate 4 ausgeschaltet (d.h. die beiden - an die Leitung 12 bzw. 10a angeschlossenen - Anschlüsse des Transfergates 4 - relativ hochohmig - elektrisch voneinander getrennt), das Transfergate 5 ein- bzw. durchgeschaltet (d.h. die beiden - an die Leitung 10a bzw. 13 angeschlossenen - Transfergate-Anschlüsse des Transfergates 5 - relativ niederohmig - elektrisch miteinander verbunden), das Transfergate 7 ausgeschaltet (d.h. die beiden - an die Leitung 10b bzw. 15 angeschlossenen - Anschlüsse des Transfergates 7 - relativ hochohmig - elektrisch voneinander getrennt), und das Transfergate 6 ein- bzw. durchgeschaltet (d.h. beiden - an die Leitung 14 bzw. 10b angeschlossenen - Transfergate-Anschlüsse des Transfergates 6 - relativ niederohmig - elektrisch miteinander verbunden).

Die Ausgangs-Leitung 11b der Takt-Receiver-Schaltungsanordnung 1 ist somit - relativ niederohmig - elektrisch mit dem an der Leitung 13 anliegenden Massepotential verbunden, und - relativ hochohmig - elektrisch von der - mit der Versorgungsspannung vddq verbundenen - Leitung 12 getrennt; das an der Ausgangs-Leitung 11b ausgegebene Takt-Signal bout ist somit - entsprechend wie das zweite Eingangs-Taktsignal bclk, und wie in Figur 2 gezeigt - "logisch hoch".

Des weiteren ist die Ausgangs-Leitung 11a der Takt-Receiver-Schaltungsanordnung 1 - relativ niederohmig - elektrisch mit der an der Leitung 14 anliegenden Versorgungsspannung vddq verbunden, und - relativ hochohmig - elektrisch von der - mit dem Massepotential verbundenen - Leitung 15 getrennt; das an der Ausgangs-Leitung 11a ausgegebene Takt-Signal out ist somit - entsprechend wie das erste Eingangs-Taktsignal clk, und wie in Figur 2 gezeigt - "logisch niedrig".

Wechselt - wie in Figur 2 dargestellt z.B. zu Beginn einer auf die erste Taktphase folgenden zweiten Taktphase, d.h. hier zu einem Zeitpunkt t1 (und insbesondere bei der o.g. Alternative) - das am ersten Taktanschluss 3a anliegende erste Taktsignal clk seinen Zustand auf "logisch hoch" (und wechselt damit auch das entsprechende, am ersten, nicht-inversen Steuereingang des Transfergates 7, am ersten, nicht-inversen Steuereingang des Transfergates 6, am zweiten, inversen Steuereingang des Transfergates 4, und am zweiten, inversen Steuereingang des Transfergates 5 anliegende Signal seinen Zustand auf "logisch hoch"), und wechselt - im wesentlichen gleichzeitig (hier: zum Zeitpunkt t1) das am zweiten Taktanschluß 3b anliegende zweite Taktsignal bclk seinen Zustand auf "logisch niedrig" (und wechselt damit auch das entsprechende, am zweiten, inversen Steuereingang des Transfergates 7, am zweiten, inversen Steuereingang des Transfergates 6, am ersten, nicht-inversen Steuereingang des Transfergates 4, und am ersten, nicht-inversen Steuereingang des Transfergates 5 anliegende Signal seinen Zustand auf "logisch niedrig"), wird das Transfergate 4 ein- bzw. durchgeschaltet (d.h. die beiden - an die Leitung 12 bzw. 10a angeschlossenen - Anschlüsse des Transfergates 4 - relativ niederohmig - elektrisch miteinander verbunden), das Transfergate 5 ausgeschaltet (d.h. beiden - an die Leitung 10a bzw. 13 angeschlossenen - Transfergate-Anschlüsse des Transfergates 5 - relativ hochohmig - elektrisch voneinander getrennt), das Transfergate 7 ein- bzw. durchgeschaltet (d.h. die beiden - an die Leitung 10b bzw. 15 angeschlossenen - Anschlüsse des Transfergates 7 - relativ niederohmig - elektrisch miteinander verbunden), und das Transfergate 6 ausgeschaltet (d.h. beiden - an die Leitung 14 bzw. 10b angeschlossenen - Transfergate-Anschlüsse des Transfergates 6 - relativ hochohmig - elektrisch voneinander getrennt).

Die Ausgangs-Leitung 11b der Takt-Receiver-Schaltungsanordnung 1 wird somit - relativ hochohmig - elektrisch von dem an der Leitung 13 anliegenden Massepotential getrennt, und - relativ niederohmig - elektrisch mit der mit der Versorgungsspannung vddq verbundenen Leitung 12 verbunden; das an der Ausgangs-Leitung 11b ausgegebene Takt-Signal bout wechselt somit - entsprechend wie das zweite Eingangs-Taktsignal bclk, und wie in Figur 2 gezeigt diesem gegenüber mit einer bestimmten Schalt-Verzögerungszeit Δt behaftet zu einem Zeitpunkt t2 - seinen Zustand auf "logisch niedrig".

Des weiteren wird die Ausgangs-Leitung 11a der Takt-Receiver-Schaltungsanordnung 1 - relativ hochohmig - elektrisch von der an der Leitung 14 anliegenden Versorgungsspannung vddq getrennt, und - relativ niederohmig - elektrisch mit der - mit dem Massepotential verbundenen - Leitung 15 verbunden; das an der Ausgangs-Leitung 11a ausgegebene Takt-Signal out wechselt somit - entsprechend wie das erste Eingangs-Taktsignal clk, und wie in Figur 2 gezeigt diesem gegenüber mit einer bestimmten Schalt-Verzögerungszeit Δt behaftet (die im wesentlichen der o.g. Schalt-Verzögerungszeit Δt des Takt-Signals bout entspricht) zu einem Zeitpunkt t2 (d.h. zum im wesentlichen demselben Zeitpunkt t2, wie das Takt-Signal bout) - seinen Zustand auf "logisch hoch".

Die an den Ausgangs-Leitungen 11a, 11b ausgegebenen, aus den Eingangs-Taktsignalen clk, bclk gewonnenen Ausgangssignale (differentielle Takt-Signale out, bout) können dann an weitere, im Halbleiter-Bauelement vorgesehene Schaltungen weitergeleitet, und dort z.B. zur zeitlichen Koordination der Verarbeitung bzw. Weiterschaltung von Daten verwendet werden.

Bei der in Figur 1 gezeigten (Takt-) Receiver-Schaltungsanordnung 1 wird die Tatsache zu Nutze gemacht, dass die Transfergates 4, 5, 6, 7 - zwischen entsprechenden Transfergate-Anschlüssen - einen jeweils variabel einstellbaren ohmschen Widerstand aufweisen, mit einem von den an den jeweiligen Steuereingängen anliegenden Steuersignalen abhängigen Widerstandswert.

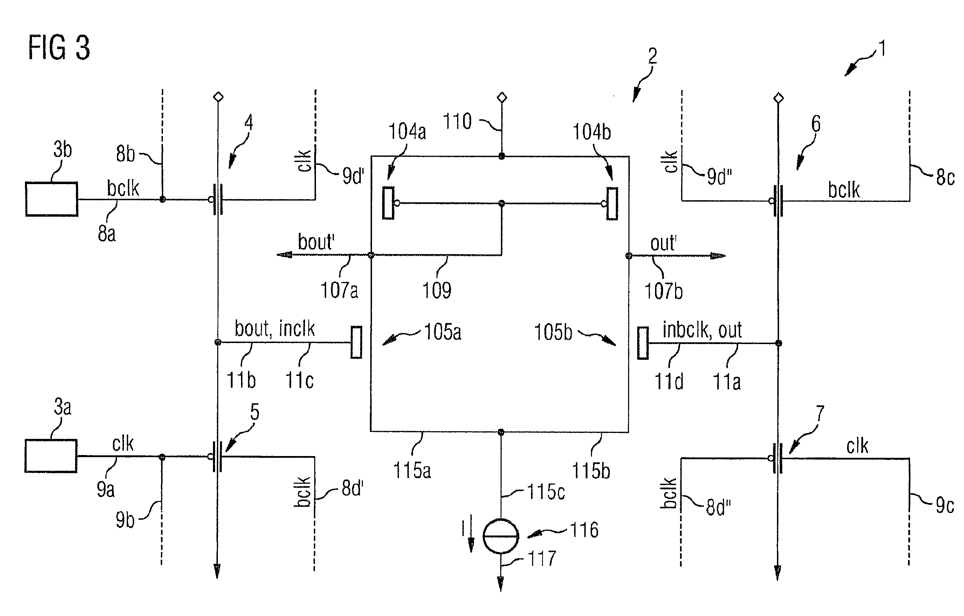

Bei einem alternativen, in Figur 3 gezeigten Ausführungsbeispiel der Erfindung können - bei einer entsprechend ähnlich, wie die in Figur 1 gezeigte Takt-Receiver-Schaltungsanordnung aufgebauten Takt-Receiver-Schaltungsanordnung 1 - die an den Ausgangs-Leitungen 11a, 11b ausgegebenen, aus den Eingangs-Taktsignalen clk, bclk gewonnenen Ausgangssignale (differentielle Takt-Signale out, bout) zum "Boosten" einer - entsprechend ähnlich wie herkömmliche Receiver-, insbesondere Takt-Receiver-Schaltungen aufgebauten - Schaltung 2 verwendet werden.

Wie aus Figur 3 hervorgeht, ist die dort gezeigte Takt-Receiver-Schaltungsanordnung 1 identisch wie die in Figur 1 gezeigte Takt-Receiver-Schaltungsanordnung 1 aufgebaut, außer dass das am ersten Taktanschluss 3a des entsprechenden Halbleiter-Bauelements anliegende, erste Taktsignal clk dem zweiten, inversen Steuereingang des Transfergates 6, und dem ersten, nicht-inversen Steuereingang des Transfergates 4 nicht über die in Figur 1 gezeigten Leitungen 9d, 9e zugeführt wird, sondern - dem Steuereingang des Transfergates 4 - über eine - z.B. an die Leitung 9b angeschlossene - separate Leitung 9d', und - dem Steuereingang des Transfergates 6 - über eine - z.B. ebenfalls an die Leitung 9b angeschlossene - separate Leitung 9d", und dass das am zweiten Taktanschluss 3b des entsprechenden Halbleiter-Bauelements anliegende, zweite Taktsignal bclk dem ersten, nicht-inversen Steuereingang des Transfergates 5, und dem zweiten, inversen Steuereingang des Transfergates 7 nicht über die in Figur 1 gezeigten Leitungen 8d, 8e zugeführt wird, sondern - dem Steuereingang des Transfergates 5 - über eine - z.B. an die Leitung 8b angeschlossene - separate Leitung 8d', und - dem Steuereingang des Transfergates 7 - über eine - z.B. ebenfalls an die Leitung 8b angeschlossene - separate Leitung 8d" .

Im übrigen wird - entsprechend wie bei dem in Figur 1 gezeigten Ausführungsbeispiel - bei der Takt-Receiver-Schaltungsanordnung 1 gemäß Figur 3 das am ersten Taktanschluss 3a anliegende, erste Taktsignal clk (zusätzlich) dem zweiten, inversen Steuereingang des Transfergates 5 zugeführt (und zwar über die Leitung 9a), und dem ersten, nicht-inversen Steuereingang des Transfergates 7 (und zwar über die Leitung 9a, und die mit dieser verbundenen Leitungen 9b, 9c).

Des weiteren wird - ebenfalls entsprechend wie bei dem in Figur 1 gezeigten Ausführungsbeispiel - bei der Takt-Receiver-Schaltungsanordnung 1 gemäß Figur 3 das am zweiten Taktanschluss 3b anliegende, zweite Taktsignal bclk (zusätzlich auch) dem zweiten, inversen Steuereingang des Transfergates 4 zugeführt (und zwar über die Leitung 8a), und dem ersten, nicht-inversen Steuereingang des Transfergates 6 (und zwar über die Leitung 8a, und die mit dieser verbundenen Leitungen 8b, 8c).

Wie aus Figur 3 hervorgeht, ist die Schaltung 2 entsprechend ähnlich wie entsprechende herkömmliche Takt-Receiver-Schaltungen aufgebaut, außer dass die Eingänge 11c, 11d der Schaltung 2 nicht - wie sonst üblich - direkt an die entsprechenden Taktanschlüsse 3a, 3b des Halbleiter-Bauelements angeschlossen sind (z.B. der Eingang 11c an den Taktanschluss 3b (oder 3a), und der Eingang 11d an den Taktanschluss 3a (oder 3b)), sondern der Eingang 11c an die Ausgangs-Leitung 11b der Takt-Receiver-Schaltungsanordnung 1 (an der, wie oben erläutert, von der Takt-Receiver-Schaltungsanordnung 1 das dem Eingangs-Taktsignal bclk entsprechende (Takt-)Signal bout ausgegeben wird), und der Eingang 11d an die Ausgangs-Leitung 11a der Takt-Receiver-Schaltungsanordnung 1 (an der, wie oben erläutert, von der Takt-Receiver-Schaltungsanordnung 1 das dem Eingangs-Taktsignal clk entsprechende (Takt-)Signal out ausgegeben wird).

Die Schaltung 2 weist - entsprechend ähnlich wie entsprechende herkömmliche Takt-Receiver-Schaltungen - vier Transistoren 104a, 104b, 105a, 105b auf, und zwar einen ersten und einen zweiten p-Kanal-Feldeffekttransistor 104a, 104b (hier: zwei p-Kanal-MOSFETs 104a, 104b), sowie einen ersten und einen zweiten n-Kanal-Feldeffekttransistor 105a, 105b (hier: zwei n-Kanal-MOSFETs 105a, 105b).

Die Source des ersten n-Kanal-Feldeffekttransistors 105a ist über eine Leitung 115a, und eine Leitung 115c an eine (Gleich- bzw. Konstant-) Strom-Quelle 116 angeschlossen, die - über eine Leitung 117 - mit dem Massepotential verbunden ist. Auf entsprechende Weise ist auch die Source des zweiten n-Kanal-Feldeffekttransistors 105b über eine Leitung 115b, und die o.g. Leitung 115c an die - mit dem Massepotential verbundene - (Gleich- bzw. Konstant-) Strom-Quelle 116 angeschlossen.

Des weiteren ist das Gate des ersten n-Kanal-Feldeffekttransistors 105a mit dem o.g. (ersten) Eingang 11c der Schaltung 2 verbunden, und das Gate des zweiten n-Kanal-Feldeffekttransistors 105b mit dem o.g. (zweiten) Eingang 11d der Schaltung 2.

Der Drain des ersten n-Kanal-Feldeffekttransistors 105a ist über eine Leitung 109 an das Gate des ersten und zweiten p-Kanal-Feldeffekttransistors 104a, 104b angeschlossen, und an den Drain des ersten p-Kanal-Feldeffekttransistors 104a, sowie - über eine Leitung 107a - an einen (ersten) Ausgang der Schaltung 2 (an der ein (erstes) Ausgangs-Signal bout' abgegriffen werden kann) .

Auf entsprechende Weise ist der Drain des zweiten n-Kanal-Feldeffekttransistors 105b an den Drain des zweiten p-Kanal-Feldeffekttransistors 104b angeschlossen, sowie - über eine Leitung 107b - an einen (zweiten) Ausgang der Schaltung 2 (an der ein (zweites) Ausgangs-Signal out' abgegriffen werden kann).

Die Source des ersten und zweiten p-Kanal-Feldeffekttransistors 104a, 104b ist - über eine Leitung 110 - jeweils an die o.g. Versorgungsspannung vddq angeschlossen.

Das erste - an der Leitung 107a ausgegebene - Ausgangs-Signal bout' der Schaltung 2 entspricht dem am Eingang 11d der Schaltung 2 anliegenden Signal out (bzw. dem Signal bout), bzw. dem am Taktanschluss 3a anliegenden Signal clk (bzw. dem am Taktanschluss 3b anliegenden Signal bclk).

Das zweite - an der Leitung 107b ausgegebene - Ausgangs-Signal out' der Schaltung 2 entspricht dem am Eingang 11c der Schaltung 2 anliegenden Signal bout (bzw. dem Signal out), bzw. dem am Taktanschluss 3b anliegenden Signal bclk (bzw. dem am Taktanschluss 3a anliegenden Signal clk).

Die an den Leitungen 107a, 107b ausgegebenen, aus den Eingangs-Taktsignalen clk, bclk gewonnenen Ausgangssignale out', bout' können an weitere, im Halbleiter-Bauelement vorgesehene Schaltungen weitergeleitet, und dort z.B. zur zeitlichen Koordination der Verarbeitung bzw. Weiterschaltung von Daten, d.h. als differentielle Takt-Signale out', bout' verwendet werden.

### Bezugszeichen

- 1: Takt-Receiver-Schaltungsanordnung
- 2: Schaltung
- 3a: Taktanschluss
- 3b: Taktanschluss
- 4: Transfergate
- 5: Transfergate
- 6: Transfergate
- 7: Transfergate
- 8a: Leitung
- 8b: Leitung
- 8c: Leitung
- 8d: Leitung
- 8d': Leitung
- 8d": Leitung
- 8e: Leitung
- 9a: Leitung
- 9b: Leitung
- 9c: Leitung
- 9d: Leitung
- 9d': Leitung
- 9d": Leitung
- 9e: Leitung
- 10a: Leitung
- 10b: Leitung
- 11a: Ausgangs-Leitung
- 11b: Ausgangs-Leitung
- 11c: Eingang
- 11d: Eingang
- 12: Leitung
- 13: Leitung
- 14: Leitung
- 15: Leitung
- 104a: Transistor
- 104b: Transistor
- 105a: Transistor
- 105b: Transistor
- 107a: Leitung
- 107b: Leitung
- 110: Leitung
- 115a: Leitung
- 115b: Leitung
- 115c: Leitung
- 116: Strom-Quelle
- 117: Leitung

## Patentansprüche

1. Halbleiter-Bauelement, mit einem ersten und einem zweiten Pad zum Empfang komplementärer Taktsignale (clk, bclk), und einer Takt-Receiver-Schaltungsanordnung (1) zum Umwandeln der empfangenen komplementären Taktsignale (clk, bclk) in komplementäre, im Vergleich zu den empfangenen Taktsignalen (clk, bclk) unterschiedliche Spannungspegel aufweisende Takt-Ausgabe-Signale (out, bout), wobei die Takt-Receiver-Schaltungsanordnung (1) einen ersten, mit dem ersten Pad verbundenen Takt-Eingang (9a) aufweist, und einen zweiten, mit dem zweiten Pad verbundenen Takt-Eingang (8a)
- wobei bei einem ersten und dritten Transfergate (5, 6) jeweils ein erster Transfergate-Steueranschluß an den zweiten Takt-Eingang (8a) der Takt-Receiver-Schaltungsanordnung (1) angeschlossen ist, und jeweils ein zweiter, zum ersten Steueranschluß inverser Transfergate-Steueranschluß an den ersten Takt-Eingang (9a) der Takt-Receiver-Schaltungsanordnung (1),
- und wobei bei einem zweiten und vierten Transfergate (4, 7) jeweils ein erster Transfergate-Steueranschluß an den ersten Takt-Eingang (9a) der Takt-Receiver-Schaltungsanordnung (1) angeschlossen ist, und jeweils ein zweiter, zum ersten Steueranschluß inverser Transfergate-Steueranschluß an den zweiten Takt-Eingang (8a) der Takt-Receiver-Schaltungsanordnung (1),
- wobei ein erster, weiterer Anschluss des ersten Transfergates (5) an eine Leitung (13), und ein erster, weiterer Anschluss des zweiten Transfergates (4) an eine zweite Leitung (12) angeschlossen ist, und ein erster, weiterer Anschluss des dritten Transfergates (6) an eine dritte Leitung (14), und ein erster, weiterer Anschluss des vierten Transfergates (7) an eine vierte Leitung (15) zum Anlegen einer ersten Spannung an den ersten, weiteren Anschluss des ersten und vierten Transfergates, und einer zweiten, hiervon unterschiedlichen Spannung an den ersten, weiteren Anschluss des zweiten und dritten Transfergates,
- wobei ein zweiter, weiterer Anschluss des ersten Transfergates (5) und ein zweiter, weiterer Anschluss des zweiten Transfergates (4) miteinander verbunden sind, und zur Ausgabe eines ersten Takt-Ausgabe-Signals (bout) - gemeinsam - an einen ersten Takt-Ausgang (11b) angeschlossen sind, und wobei ein zweiter, weiterer Anschluss des dritten Transfergates (6) und ein zweiter, weiterer Anschluss des vierten Transfergates (7) miteinander verbunden sind, und zur Ausgabe eines zweiten, zum ersten Takt-Ausgabe-Signal (bout) komplementären Takt-Ausgabe-Signals (out) - gemeinsam - an einen zweiten Takt-Ausgang (11a) angeschlossen sind.

2. Halbleiter-Bauelement nach Anspruch 1, welches außerdem eine Takt-Weiterleitungs-Schaltung (2) aufweist.

3. Halbleiter-Bauelement nach Anspruch 2, wobei der erste Takt-Ausgang (11b) an einen ersten Eingang der Takt-Weiterleitungs-Schaltung (2), und der zweite Takt-Ausgang (11a) an einen zweiten Eingang der Takt-Weiterleitungs-Schaltung (2) angeschlossen ist.

4. Halbleiter-Bauelement nach Anspruch 2 oder 3, bei welchem die Takt-Weiterleitungs-Schaltung (2) vier Transistoren (104a, 104b, 105a, 105b) aufweist.

## Claims

1. A semiconductor device comprising a first and a second pad for receiving complementary clock signals (clk, bclk), and a clock receiver circuit arrangement (1) for converting the received complementary clock signals (clk, bclk) in complementary clock output signals (out, bout) having different voltage levels vis-à-vis the received clock signals (clk, bclk), wherein the clock receiver circuit arrangement (1) comprises a first clock input (9a) connected with the first pad, and a second clock input (8a) connected with the second pad
- wherein, at a first and third transfer gate (5, 6), a first transfer gate control connection is connected to said second clock input (8a) of said clock receiver circuit arrangement (1), and a second transfer gate control connection that is inverse to said first control connection is connected to said first clock input (9a) of said clock receiver circuit arrangement (1),
- and wherein, at a second and fourth transfer gate (4, 7), a first transfer gate control connection is connected to said first clock input (9a) of said clock receiver circuit arrangement (1), and a second transfer gate control connection that is inverse to said first control connection is connected to said second clock input (8a) of said clock receiver circuit arrangement (1),
- wherein a first, further connection of said first transfer gate (5) is connected to a line (13), and a first, further connection of said second transfer gate (4) is connected to a second line (12), and a first, further connection of said third transfer gate (6) is connected to a third line (14), and a first, further connection of said fourth transfer gate (7) to a fourth line (15) for applying a first voltage to said first, further connection of said first and fourth transfer gates, and a second, different voltage to said first, further connection of said second and third transfer gates,
- wherein a second, further connection of said first transfer gate (5) and a second, further connection of said second transfer gate (4) are connected with each other and are - jointly - connected to a first clock output (11b) for outputting a first clock output signal (bout), and wherein a second, further connection of said third transfer gate (6) and a second, further connection of said fourth transfer gate (7) are connected with each other and are - jointly - connected to a second clock output (11a) for outputting a second clock output signal (out) that is complementary to said first clock output signal (bout).

2. The semiconductor device according to claim 1, which further comprises a clock transfer circuit (2).

3. The semiconductor device according to claim 2, wherein said first clock output (11b) is connected to a first input of said clock transfer circuit (2), and said second clock output (11a) is connected to a second input of said clock transfer circuit (2).

4. The semiconductor device according to claims 2 or 3, wherein said clock transfer circuit (2) comprises four transistors (104a, 104b, 105a, 105b).

## Revendications

1. Composant à semi-conducteur, comprenant un premier affaiblisseur et un second affaiblisseur pour la réception de signaux d'horloge (clk, bclk) complémentaires et un agencement de circuit récepteur de signaux d'horloge (1) pour la conversion des signaux d'horloge (clk, bclk) complémentaires reçus en signaux de sortie d'horloge (out, bout) complémentaires et présentant des niveaux de tension différents par rapport aux signaux d'horloge (clk, bclk) reçus, l'agencement de circuit récepteur de signaux d'horloge (1) présentant une première entrée d'horloge (9a) reliée au premier affaiblisseur, et une seconde entrée d'horloge (8a) reliée au second affaiblisseur,
- dans le cas d'une première et d'une troisième portes de transfert (5, 6), respectivement un premier branchement de commande de porte de transfert étant raccordé à la seconde entrée d'horloge (8a) de l'agencement de circuit récepteur de signaux d'horloge (1), un second branchement de commande de porte de transfert, inversé par rapport au premier branchement de commande, étant raccordé à la première entrée d'horloge (9a) de l'agencement de circuit récepteur de signaux d'horloge (1),
- et, dans le cas d'une seconde et d'une quatrième portes de transfert (4, 7), respectivement un premier branchement de commande de porte de transfert étant raccordé à la première entrée d'horloge (9a) de l'agencement de circuit récepteur de signaux d'horloge (1), et un second branchement de commande de porte de transfert inversé par rapport au premier branchement de commande étant raccordé à la seconde entrée d'horloge (8a) de l'agencement de circuit récepteur de signaux d'horloge (1),
- un premier autre branchement de la première porte de transfert (5) étant raccordé à une ligne (13), et un premier autre branchement de la seconde porte de transfert (4) étant raccordé à une seconde ligne (12), et un premier autre branchement de la troisième porte de transfert (6) étant raccordé à une troisième ligne (14), et un premier autre branchement de la quatrième porte de transfert (7) étant raccordé à une quatrième ligne (15) pour l'application d'une première tension sur le premier autre branchement de la première et de la quatrième portes de transfert, et d'une seconde tension différente de la première sur le premier autre branchement de la deuxième et de la troisième portes de transfert,
- un second autre branchement de la première porte de transfert (5) et un second autre branchement de la seconde porte de transfert (4) étant reliés entre eux, et étant raccordés ensemble à une première sortie d'horloge (11b) pour la sortie d'un premier signal de sortie d'horloge (bout), et un second autre branchement de la troisième porte de transfert (6) et un second autre branchement de la quatrième porte de transfert (7) étant reliés entre eux, et étant raccordés ensemble à une seconde sortie d'horloge (11a) pour la sortie d'un second signal de sortie d'horloge (out) complémentaire du premier signal de sortie d'horloge (bout).

2. Composant à semi-conducteur selon la revendication 1, lequel présente d'autre part un circuit de réacheminement de signaux d'horloge (2).

3. Composant à semi-conducteur selon la revendication 2, la première sortie d'horloge (11b) étant raccordée à une première entrée du circuit de réacheminement de signaux d'horloge (2), et la seconde sortie d'horloge (11a) à une seconde entrée du circuit de réacheminement de signaux d'horloge (2).

4. Composant à semi-conducteur selon la revendication 2 ou 3, sur lequel le circuit de réacheminement de signaux d'horloge (2) présente quatre transistors (104a, 104b, 105a, 105b).
